Europäisches Patentamt

European Patent Office

Office européen des brevets

(11) Publication number: **0 087 919**
**B1**

## EUROPEAN PATENT SPECIFICATION

(45) Date of publication of patent specification: **11.10.89**

(51) Int. Cl.⁴: **G 11 C 11/40, G 11 C 8/00**

(21) Application number: **83300945.9**

(22) Date of filing: **23.02.83**

(54) A static type semiconductor memory device including a word line discharging circuit.

(30) Priority: **27.02.82 JP 29796/82**

(43) Date of publication of application:
**07.09.83 Bulletin 83/36**

(45) Publication of the grant of the patent:
**11.10.89 Bulletin 89/41**

(84) Designated Contracting States:
**DE FR GB**

(56) References cited:
**EP-A-0 025 316**

**IEEE INTERNATIONAL SOLID-STATE CIRCUITS
CONFERENCE DIGEST OF TECHNICAL
PAPERS, 16th February 1978, pages 98-99,
IEEE, New York, US; A. HOTTA et al.: "Session
IX: static and nonvolatile memories: Tham 9.1:
A high-speed low-power 4096 x 1-bit bipolar
RAM"**

(73) Proprietor: **FUJITSU LIMITED
1015, Kamikodanaka Nakahara-ku
Kawasaki-shi Kanagawa 211 (JP)**

(72) Inventor: **Kitano, Kouichi
29-9, Higashimukojima 6-chome
Sumida-ku Tokyo 131 (JP)**

(74) Representative: **Skone James, Robert Edmund
et al
GILL JENNINGS & EVERY 53-64 Chancery Lane
London WC2A 1HN (GB)**

Courier Press, Leamington Spa, England.

## Description

The present invention relates to a word line discharging circuit in a static-type semiconductor memory device of, for example, an emitter-coupled logic device, an injected injection logic device, and so forth, using bipolar transistors.

Generally, in the above-mentioned static-type semiconductor memory device, memory cells in one row are connected between a word line and a hold line. In order to hold the memory status, i.e., the status of the flip-flop, of each memory cell, a holding current flows from the word line through the memory cell and the hold line to a holding current source. The selection of such a word line is effected by boosting the electric potential of the word line by means of a word driver. In this case, since the word driver is an emitter follower, the time for changing the word line from an unselected state to a selected state, that is, the rise time of the word line, is short. In contrast, the time for changing the word line from a selected state to an unselected state, that is, the fall time of the word line, depends on the amount of charges stored in the parasitic capacitances of the word line and on the amount of holding current. This is because the emitter follower, i.e., the word driver, is cut off during the fall time. However, recently, semiconductor memory devices of a large scale and having a low power consumption have been developed. Accordingly, the amount of holding current is becoming smaller so that the fall time of the word line tends to become long.

In order to shorten the fall time of the above-mentioned word line, a word-line discharging circuit has been employed for conducting a concentrated discharge current through the word line, which is transferring from a selected state to an unselected state, that is, for conducting a discharge current, in addition to the regular holding current, through the above-mentioned word line, and for keeping the discharging current flowing through the above-mentioned word line for a certain time period.

A conventional word-line discharging circuit comprises, for each word line, a first transistor which is an emitter follower and which is switched in response to the electric potential of the word line, a time-constant circuit consisting of a first resistor and a capacitor, a second transistor switched by the output of the time-constant circuit, and a second resistor connected between the base of the second transistor and a common bias-current source. The second transistor has a collector connected to the corresponding hold line and an emitter directly connected to a common discharging current source. Therefore, the second transistors provided between the common discharging current source and the respective word rose constitute a current switch. That is, when a certain word line transfers from an unselected state to a selected state, the first transistor turns on and then after a time constant determined by the resistor and the capacitor of the time-constant circuit, the second transistor turns on so that the current flowing through the selected word line and through the memory cells connected to the word line is increased by the current from the common discharging current source in addition to the regular holding current. Simultaneous with the transfer of the above-mentioned word line to the selected state, another word line transfers from a selected state to an unselected state so that the first transistor of the corresponding word line is turned off, and until the charges stored in the capacitor of the time-constant circuit are discharged through the second resistor, the discharging current from the common discharging current source is held. Therefore, the charges on the word line which has been changed to the unselected state are rapidly decreased so that the fall time of the word line is shortened. (EP—A—25316).

In the above-described conventional circuit, a problem exists in that, along with the recent miniaturization and the development of a large-scale memory-cell structure, the amount of holding current flowing through the memory cells tends to become small. Also, along with the decrease in the current flowing from the word line through the memory cells to the word line discharging circuit, the phenomenon of decreasing junction capacitance in the memory cell occurs. Therefore, when a word line transfers from a selected state to an unselected state, the value of the current flowing through the memory cell after the word line potential falls is smaller than that before the word line potential falls. Thus, the amount of charges which can be stored in the memory cell is decreased after the word line potential falls. As a result, after the word line potential falls, the charges stored in the memory cell before the word line potential falls overflow on the word line so that potential is boosted again. Thus, conventionally, there has been the problem of the phenomenon of double selection of the selected word line and a word line transferred from a selected state to an unselected state.

In accordance with one aspect of the present invention, a semiconductor memory device comprises a plurality of pairs of word lines and hold lines; a plurality of memory cells each connected between pairs of the word lines and hold lines; a plurality of holding current sources, connected between respective hold lines and a voltage source, for continually drawing holding currents from the word lines through the memory cells to the hold lines and a word line discharging circuit comprising first transistors having bases connected to respective word lines for detecting changes in the electric potentials of the word lines, time-constant circuits for delaying the outputs of the first transisistors, a common discharging current source, and second transistors respectively inserted between the hold lines and the common discharging current source, the second transistors operatively being switched in response to the outputs of the time-constant circuits, and is characterised in that smoothing means is provided between the hold lines and the common discharging current source for smoothing changes in the current flowing from the hold lines to the common discharging current source, the smoothing means being coupled with the hold lines via the second transistors.

The present invention prevents double selection of the word lines and ensures the selection of a memory cell.

Preferably, the second transistors are NPN transistors each having a collector connected to the corresponding hold line, a base connected to the output of the corresponding time-constant circuit, and an emitter, the smoothing means comprising a resistor connected between the emitter of each of the second NPN transistors and the common discharging current source.

In one example, the second transistors are NPN transistors each having a collector connected to the corresponding hold line, an emitter connected to the common discharging current source, and a base, the smoothing means being formed by the second transistors each having a resistor connected between the base of the second NPN transistor and the output of the corresponding time-constant circuit.

In accordance with a second aspect of the present invention, a static-type semiconductor memory device comprises a plurality of pairs of word lines and hold lines; a plurality of memory cells each connected between pairs of the word lines and hold lines; a plurality of holding current sources connected between respective hold lines and a voltage source, for continually drawing holding currents from the word lines through the memory cells to the hold lines; and a word line discharging circuit comprising first transistors, having bases connected to respective word lines for detecting changes in the electric potentials of the word lines, time-constant circuits for delaying the outputs of the first transistors, a common discharging current source, and second transistors respectively inserted between the hold lines and the common discharging current source, the second transistors operatively being switched in response to the outputs of the time-constant circuits, and is characterised in that smoothing means is provided between the hold lines and the common discharging current source for smoothing changes in the current flowing from the hold lines to the common discharging current source, the smoothing means being provided by the second transistors each of which are NPN transistors having an emitter connected to the corresponding hold line, a collector connected to the common discharging current source, and a base connected to the output of the corresponding time-constant circuit.

Some examples of semiconductor memory devices in accordance with the present invention will now be described with reference to the accompanying drawings, in which:—

Figure 1 is a circuit diagram illustrating a first example of a main portion of a static-type semiconductor memory device;

Figure 2A is a waveform diagram illustrating the potential changes of the row address signals applied to the static-type semiconductor device of Fig. 1;

Figure 2B is a waveform diagram illustrating the changes in the current flowing through the word line discharging circuit in the device of Fig. 1;

Figure 2C is a waveform diagram illustrating the potential changes of the word lines in the device of Figure 1; and,

Figures 3 and 4 are circuit diagrams illustrating main portions of the word line discharging circuits of two further examples.

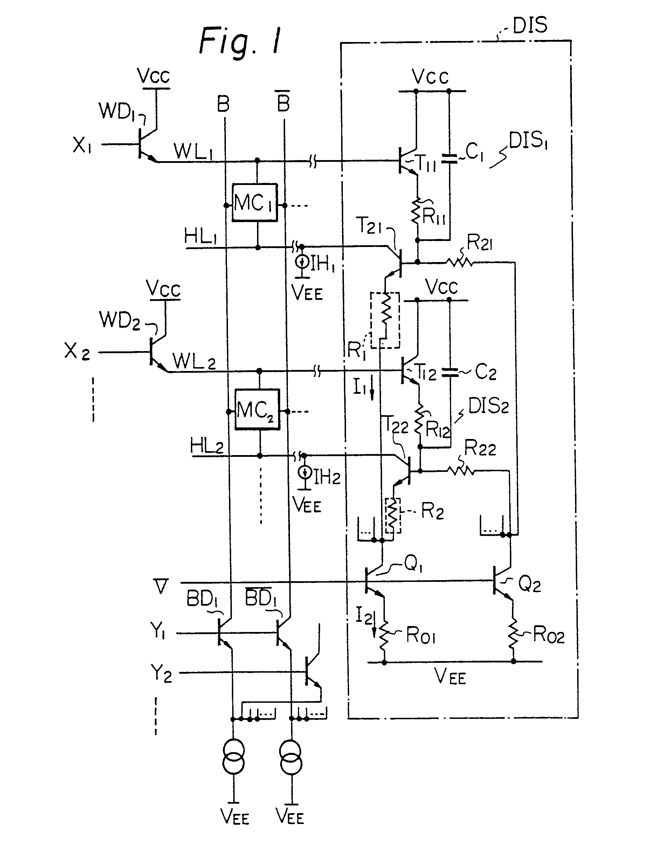

Figure 1 is a circuit diagram illustrating a main portion of a static-type semiconductor memory device, according to an embodiment of the present invention. In Fig. 1, $MC_1$, $MC_2$, - - - are flip-flop-type memory cells; $WL_1$, $WL_2$, - - - are word lines; $HL_1$, $HL_2$, - - - are hold lines; B and $\bar{B}$ are a pair of bit lines; $WD_1$ and $WD_2$ are word drivers for driving the word lines $WL_1$ and $WL_2$, respectively; $BD_1$ and $\overline{BD_1}$ are bit drivers for driving the bit lines B and $\bar{B}$; and $IH_1$, $IH_2$, - - - are holding current sources respectively connected between the respective hold lines and a negative voltage source $V_{EE}$. The memory cells $MC_1$, $MC_2$, - - - are arranged in a matrix so as to construct a memory cell array MCA. The other memory cells, word drivers, and bit drivers are not illustrated for the sake of simplicity. One memory cell, for example, $MC_1$, is selected by turning on one of the word drivers, e.g., $WD_1$, and one pair of bit drivers, e.g., $BD_1$ and $\bar{B}D_1$. $X_1$, $X_2$, - - - are row address signals which are turned to the high potential "H" in a selected state so as to turn on the corresponding word driver. $Y_1$, $Y_2$, - - - are column address signals which are turned to the high potential "H" in a selected state so as to turn on the corresponding pair of bit drivers. DIS is a word-line discharging circuit consisting of terminating circuits $DIS_1$, $DIS_2$, - - - each of which is connected to the end of a word line and to the end of a hold line. Now the terminating circuit $DIS_1$ is mainly explained. The other terminating circuits $DIS_2$, $DIS_3$, - - - have configurations similar to the configuration of the terminating circuit $DIS_1$. The terminating circuit $DIS_1$ comprises a first transistor $T_{11}$ of an emitter follower having a base connected to the word line $WL_1$; a time-constant circuit consisting of a resistor $R_{11}$ and a capacitor $C_1$ for delaying the emitter output of the transistor $T_{11}$; a second transistor $T_{21}$ having a base for receiving the output of the time-constant circuit and having a collector connected to the hold line $HL_1$, which is turned on (so as to be conductive) or off (so as to be non-conductive) depending on the output of the time-constant circuit; and a resistor $R_{21}$ connected between the base of the second transistor and a common bias current source consisting of a transistor $Q_2$ and a resistor $R_{02}$. A transistor $Q_1$ and a resistor $R_{01}$ constitute a common current source for discharging the charges on the word lines. By continually applying a constant voltage V to the bases of the

transistors $Q_1$ and $Q_2$, a discharging current is forced to flow through a word line which is transferring from a selected state to an unselected state, as is described in detail later.

Conventionally, the emitters of the second transistors $T_{21}$, $T_{22}$, - - - are directly connected to the collector of the transistor $Q_1$, which, along with the resistor $R_{01}$, constitutes the common current source for discharging the charges on the word lines. In contrast, in this embodiment, the emitters of the second transistors $T_{21}$, $T_{22}$, - - - are connected via resistors $R_1$, $R_2$, - - - to the second common current source.

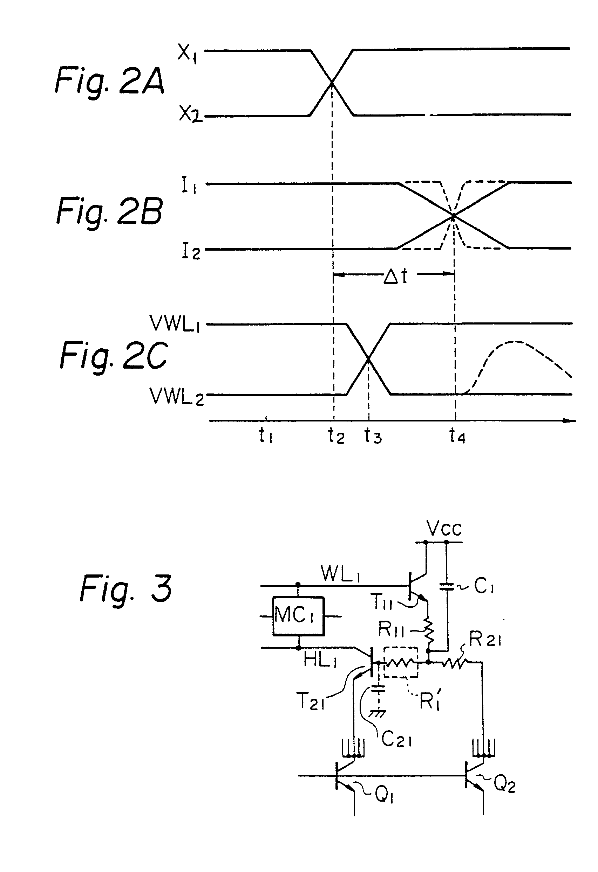

The operation of the circuit of Fig. 1 will now be explained with reference to Figs. 2A through 2C. Figure 2A is a waveform diagram illustrating the electric potential changes of the row address signals $X_1$ and $X_2$. Figure 2B illustrates the changes in the current flowing through the emitters of the second transistors $T_{21}$ and $T_{22}$, the currents being changed in response to the switching of the electric potentials of the row address signals $X_1$ and $X_2$. Figure 2C illustrates the electric potential changes of the word lines $WL_1$ and $WL_2$. At a time $t_1$, the row address signal $X_1$ is at the H level and the row address signal $X_2$ is at the L level, and, therefore, the word line $WL_1$ is in a selected state and the word line $WL_2$ is in an unselected state. At this time, the first transistor $T_{11}$ and the second transistor $T_{21}$ in the terminating circuit $DIS_1$ are both conductive so that, as is illustrated in Fig. 2B, a large current flows from the word line $WL_1$ through the selected-state memory cell $MC_1$, the hold line $HL_1$, the second transistor $T_{21}$, and the resistor $R_1$ to the common discharging current source consisting of the transistor $Q_1$ and the resistor $R_{01}$. Also, a first transistor $T_{12}$ and the second transistor $T_{22}$ in the terminating circuit $DIS_2$ are both non-conductive so that only a small current flows from the unselected word line $WL_2$ through the memory cells, e.g., $MC_2$, connected in this row, to the holding current source $IH_2$. At this time $t_1$, the potential of the word line $WL_1$ is at the "H" level and the potential of the word line $WL_2$ is at the "L" level, as is illustrated in Fig. 2C.

At a time $t_2$, when the potentials of the row address signals $X_1$ and $X_2$ are switched, the word driver $WD_1$ is turned off and the word driver $WD_2$ is turned on so that at a time $t_3$ slightly later than the time $t_2$, the potential of the word line $WL_1$ is switched to the "L" level and the potential of the word line $WL_2$ is switched to the "H" level. Also, in response to the switching of the word line $WL_1$ from the "H" level to the "L" level, the first transistor $T_{11}$ in the terminating circuit $DIS_1$ is turned off. However, the second transistor $T_{21}$ in the terminating circuit $DIS_1$ is not turned on until a time constant $\Delta t$ determined by the time-constant circuit, consisting of the resistor $R_{11}$ and the capacitor $C_1$, has passed because the change in the potential at the emitter of the first transistor $T_{11}$ is transferred to the base of the second transistor $T_{21}$ only after the above-mentioned time constant $\Delta t$.

Therefore, even after the potential of the word line $WL_1$ is switched to the "L" level, a discharging current continues to flow through the word line $WL_1$ until a time $t_4$, which is later than the time $t_3$, so that the charges stored in the floating capacitors included in the hold line $HL_1$ and the memory cells, e.g., $MC_1$, connected in this row are discharged to accelerate the lowering of the potential of the word line $WL_1$. On the other hand, in the terminating circuit $DIS_2$, in response to the row address signal $X_2$, which is switched at the time $t_2$ from an unselected state to a selected state, the potential of the word line $WL_2$ rises, and, after the transistor $T_{12}$ is turned on so as to be conductive, the second transistor $T_{22}$ begins to be conductive at the time $t_4$, which is later than the time $t_3$, due to the resistor $R_{12}$ and the capacitor $C_2$, so that only after the time $t_4$ does the current from the common discharging current source flow through the word line $WL_2$, which has been turned on so as to be in a selected state.

Conventionally, the resistor $R_1$ or $R_2$ is not connected between the emitter of the second transistor and the common discharging current source. Therefore, as is illustrated by the broken curves in Fig. 2B, the current flowing through the word line $WL_1$, which is changed from a selected state to an unselected state, is rapidly decreased. Due to this rapid decrease of the current, the charges stored in the memory cells flood out onto the word line $WL_1$, resulting in a phenomenon in which the potential of the word line $WL_1$, which has been turned off so as to be in the unselected state, is raised again, as is illustrated by the dotted curve in Fig. 2C. This phenomenon can be explained by the fact that the floating capacity of the PN junctions in the memory cell is rapidly decreased due to the rapid decrease of the current flowing therethrough. Accordingly, double selection inconveniently occurs in the conventional art.

In this embodiment, by inserting the resistors $R_1$, $R_2$, - - - between the respective emitters of the second transistors $T_{21}$, $T_{22}$, - - - and the collector of the transistor $Q_1$ in the common discharging current source, the changes of the discharging current flowing through the word lines $WL_1$, $WL_2$, - - - or through the emitters of the second trumsistors $T_{21}$, $T_{22}$, - - - are blunted, as is illustrated by the solid curves in Fig. 2B. This blunting effect can be obtained, as can easily be seen by those skilled in the art, due to the current-limiting effect of the resistors $R_1$, $R_2$, - - -. As a result, the floating capacity of the PN junctions in the memory cell is gradually decreased due to the gradual change of the word line. Therefore, the potential of the word line, which has been turned off so as to be in the unselected state, is not increased again unless the word line is switched on so as to be in a selected state. Thus, the problem of double selection is solved.

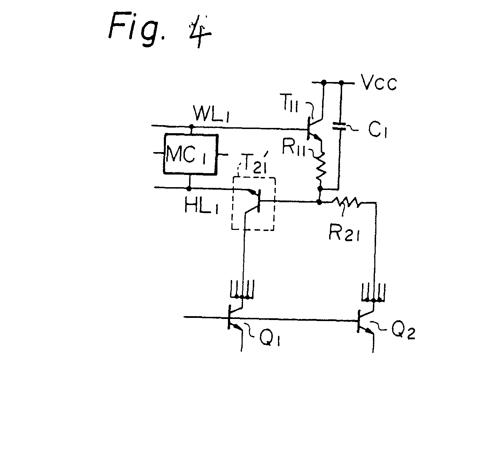

Figures 3 and 4 are circuit diagrams illustrating main portions of word-line discharging circuits, according to other embodiments of the present invention, respectively. In Figs. 3 and 4, only terminating circuits corresponding to the ter-

minating circuit $DIS_1$ in Fig. 1 are illustrated in detail. The other terminating circuits are similar to the terminating circuits of Figs. 3 and 4 and, therefore, are not illustrated for the sake of simplicity. In Fig. 1, as a means for blunting the changes in the current flowing through the word line, the resistor $R_1$ or $R_2$ was inserted between the emitter of the second transistor $T_{21}$ or $T_{22}$ and the collector of the transistor $Q_1$ constituting, along with the resistor $R_{01}$, the common discharging current source. In contrast, in Fig. 3, in place of the resistor $R_1$ or $R_2$, a resistor $R_1'$ is inserted between the base of the second transistor $T_{21}$ and a common connecting point of the resistor $R_{11}$ and the capacitor $C_1$, which constitute the time-constant circuit. By inserting the resistor $R_1'$ between the output of the time-constant circuit and the base of the second transistor $T_{21}$, as mentioned above, the frequency characteristics of the second transistor $T_{21}$ can said to be equivalently deteriorated because the second transistor $T_{21}$ has at its base a parasitic capacitance $C_{21}$, resulting in effects similar to those in the circuit of Fig. 1. A third embodiment is illustrated in Fig. 4. In Fig. 4, in place of the second NPN transistor $T_{21}$ in Fig. 1, an NPN transistor $T_{21}'$ is employed. The NPN transistor $T_{21}'$ has an emitter connected to the hold line $HL_1$ and a collector directly connected to the discharging current source, i.e., not connected via a resistor. That is, the collector and the emitter of the transistor $T_{21}$ in Fig. 1 are interchanged so as to realize the transistor $T_{21}'$. Due to this connection, the response speed of the NPN transistor $T_{21}'$ at a high frequency is deteriorated, resulting in effects similar to those in the circuit of Fig. 1.

**Claims**

1. A static-type semiconductor memory device comprising a plurality of pairs of word lines ($WL_1$, $WL_2$) and hold lines ($HL_1$, $HL_2$); a plurality of memory cells ($MC_1$, $MC_2$) each connected between pairs of the word lines and hold lines; a plurality of holding current sources ($IH_1$, $IH_2$) connected between respective hold lines and a voltage source ($V_{EE}$), for continually drawing holding currents from the word lines through the memory cells to the hold lines; and a word line discharging circuit ($DIS_1$, $DIS_2$) comprising first transistors ($T_{11}$, $T_{12}$) having bases connected to respective word lines for detecting changes in the electric potentials of the word lines, time-constant circuits ($C_1$, $R_{11}$) for delaying the outputs of the first transistors, a common discharging current source ($Q_1$, $R_{01}$), and second transistors ($T_{21}$, $T_{22}$) respectively inserted between the hold lines and the common discharging current source, the second transistors operatively being switched in response to the outputs of the time-constant circuits, characterised in that smoothing means is provided between the hold lines and the common discharging current source for smoothing changes in the current flowing from the hold lines to the common discharging current source, the smoothing means being coupled with the hold lines via the second transistors.

2. A memory device according to claim 1, wherein the second transistors ($T_{21}$, $T_{22}$) are NPN transistors each having a collector connected to the corresponding hold line ($HL_1$, $HL_2$), a base connected to the output of the corresponding time-constant circuit, and an emitter, the smoothing means comprising a resistor ($R_1$, $R_2$) connected between the emitter of each of the second NPN transistors and the common discharging current source ($Q_1$, $R_{01}$).

3. A memory device according to claim 1, wherein the second transistors ($T_{21}$, $T_{22}$) are NPN transistors each having a collector connected to the corresponding hold line ($HL_1$, $HL_2$), an emitter connected to the common discharging current source ($Q_1$, $R_{01}$), and a base, the smoothing means being formed by the second transistors each having a resistor ($R_1$) connected between the base of the second NPN transistor and the output of the corresponding time-constant circuit.

4. A static-type semiconductor memory device comprising a plurality of pairs of word lines ($WL_1$, $WL_2$) and hold lines ($HL_1$, $HL_2$); a plurality of memory cells ($MC_1$, $MC_2$) each connected between pairs of the word lines and hold lines; a plurality of holding current sources ($IH_1$, $IH_2$) connected between respective hold lines and a voltage source ($V_{EE}$), for continually drawing holding currents from the word lines through the memory cells to the hold lines; and a word line discharging circuit ($DIS_1$, $DIS_2$) comprising first transistors ($T_{11}$, $T_{12}$) having bases connected to respective word lines for detecting changes in the electric potentials of the word lines, time-constant circuits ($C_1$, $R_{11}$) for delaying the outputs of the first transistors, a common discharging current source ($Q_1$, $R_{01}$), and second transistors ($T_{21}$, $T_{22}$) respectively inserted between the hold lines and the common discharging current source, the second transistors operatively being switches in response to the outputs of the time-constant circuits, characterised in that smoothing means is provided between the hold lines and the common discharging current source for smoothing changes in the current flowing from the hold lines to the common discharging current source, the smoothing means being provided by the second transistors each of which are NPN transistors ($T_{21}'$) having an emitter connected to the corresponding hold line ($WL_1$), a collector connected to the common discharging current source ($Q_1$, $R_{01}$), and a base connected to the output of the corresponding time-constant circuit.

**Patentansprüche**

1. Statische Halbleiterspeichervorrichtung mit einer Vielzahl von Paaren von Wortleitungen ($WL_1$, $WL_2$) und Halteleitungen ($HL_1$, $HL_2$); einer Vielzahl von Speicherzellen ($MC_1$, $MC_2$), die jeweils zwischen Paaren der Wortleitungen und Halteleitungen verbunden sind; einer Vielzahl von Haltestromschaltungen ($IH_1$, $IH_2$), die zwischen

entsprechenden Halteleitungen verbunden sind, und einer Spannungsquelle ($V_{EE}$), um kontinuierlich Halteströme über die Speicherzellen von den Wortleitungen zu den Halteleitungen zu ziehen; und einer Wortleitungs-Entladungsschaltung ($DIS_1$, $DIS_2$), die erste Transistoren ($T_{11}$, $T_{12}$) umfaßt, die Basen haben, die mit jeweiligen Wortleitungen verbunden sind, um Änderungen der elektrischen Potentiale der Wortleitungen zu detektieren, Zeitkonstanten-Schaltungen ($C_1$, $R_{11}$), zum Verzögern der Ausgänge von den ersten Transistoren, einer gemeinsamen Entladungsstromquelle ($Q_1$, $R_{01}$), und zweiten Transistoren ($T_{21}$, $T_{22}$), die jeweils zwischen den Halteleitungen und der gemeinsamen Entladungsstromquelle verbunden sind, wobei die zweiten Transistoren wirkungsmäßig in Abhängigkeit von den Ausgängen der Zeitkonstanten-Schaltungen geschaltet werden, dadurch gekennzeichnet, daß Glättungseinrichtungen zwischen den Halteleitungen und der gemeinsamen Entladungsstromquelle vorgesehen sind, um Änderungen des Stromes, der von den Halteleitungen zu der gemeinsamen Entladestromquelle fließt, zu glätten, wobei die Glättungseinrichtungen über die zweiten Transistoren mit den Halteleitungen gekoppelt sind.

2. Speichervorrichtung nach Anspruch 1, bei der die genannten zweiten Transistoren ($T_{21}$, $T_{22}$) NPN-Transistoren sind, die jeweils einen Kollektor haben, der mit der entsprechenden Halteleitung ($HL_1$, $HL_2$) verbunden ist, eine Basis, die mit dem Ausgang der entsprechenden Zeitkonstanten-Schaltung verbunden ist, und einen Emitter, wobei die Glättungseinrichtungen einen Widerstand ($R_1$, $R_2$) umfassen, der zwischen dem Emitter von jedem der zweiten NPN-Transistoren und der gemeinsamen Entladestromquelle ($Q_1$, $R_{01}$) verbunden ist.

3. Speichervorrichtung nach Anspruch 1, bei der die zweiten Transistoren ($T_{21}$, $T_{22}$) NPN-Transistoren sind, die jeweils einen Kollektor haben, der mit der entsprechenden Halteleitung ($HL_1$, $HL_2$) verbunden ist, einen Emitter, der mit der gemeinsamen Entladestromquelle ($Q_1$, $R_{01}$) verbunden ist, und eine Basis, und die Glättungseinrichtungen, die durch die zweiten Transistoren gebildet sind, jeweils einen Widerstand ($R_1$) haben, der zwischen der Basis des zweiten NPN-Transistors und dem Ausgang der entsprechenden Zeitkonstantenschaltung verbunden ist.

4. Statische Halbleiterspeichervorrichtung mit einer Vielzahl von Paaren von Wortleitungen ($WL_1$, $WL_2$) und Halteleitungen ($HL_1$, $HL_2$); einer Vielzahl von Speicherzellen ($MC_1$, $MC_2$), die jeweils zwischen Paaren von den Wortleitungen und den Halteleitungen verbunden sind; einer Vielzahl von Haltestromquellen ($IH_1$, $IH_2$), die zwischen entsprechenden Halteleitungen und einer Spannungsquelle ($V_{EE}$) verbunden sind, um kontinuierlich Halteströme von den Wortleitungen über die Speicherzellen zu den Halteleitungen zu ziehen; und eine Wortleitungsentladungsschaltung ($DIS_1$, $DIS_2$), die erste Transistoren ($T_{11}$, $T_{12}$) umfaßt, die Basen haben, die mit jeweiligen Wortleitungen verbunden sind, um Änderungen in den elektrischen Potentialen der Wortleitungen zu detektieren, Zeitkonstanten-Schaltungen ($C_1$, $R_{11}$) zur Verzögerung der Ausgänge von den ersten Transistoren, eine gemeinsame Entladestromquelle ($Q_1$, $R_{01}$), und zweite Transistoren ($T_{21}$, $T_{22}$), die jeweils zwischen den Halteleitungen und der gemeinsamen Entladestromquelle eingefügt sind, wobei die zweiten Transistoren wirkungsmäßig in Abhängigkeit von den Ausgängen der Zeitkonstanten-Schaltungen geschaltet werden, dadurch gekennzeichnet, daß Glättungseinrichtungen zwischen den Halteleitungen und der gemeinsamen Entladestromquelle vorgesehen sind, um Änderungen des Stromes, der von den Halteleitungen zu der gemeinsamen Entladestromquelle fließt, zu glätten, wobei die Glättungseinrichtungen durch die zweiten Transistoren gebildet werden, die jeweils NPN-Transistoren ($T_{21}'$) sind, die einen Emitter haben, der mit der entsprechenden Halteleitung ($WL_1$) verbunden ist, einen Kollektor, der mit der gemeinsamen Entladestromquelle ($Q_1$, $R_{01}$) verbunden ist, und eine Basis, die mit dem Ausgang der entsprechenden Zeitkonstanten-Schaltung verbunden ist.

## Revendications

1. Dispositif de mémoire à semiconducteur du type statique comprenant un ensemble de paires de fils de mot ($WL_1$, $WL_2$) et de fils de maintien ($HL_1$, $HL_2$); un ensemble de cellules de mémoire ($MC_1$, $MC_2$) connectées chacunes entre les paires de fils de mot et de fils de maintien; un ensemble de sources de courant de maintien ($IH_1$, $IH_2$) connectées entre les fils de maintien respectifs et une source de tension ($V_{EE}$), pour faire passer d'une façon continue des courants de maintien des fils de mot aux fils de maintien par l'intermédiare des cellules de mémoire; et un circuit de décharge de fil de mot ($DIS_1$, $DIS_2$) comprenant des premiers transistors ($T_{11}$, $T_{12}$) comportant des bases connectées aux fils de mot respectifs pour détecter les variations des potentiels électriques des fils de mot, des circuits à constante de temps ($C_1$, $R_{11}$) pour retarder les signaux de sortie des premiers transistors, une source de courant de décharge commune ($Q_1$, $R_{01}$), et des deuxièmes transistors ($T_{21}$, $T_{22}$) insérés respectivement entre les fils de maintien et la source de courant de décharge commune, les deuxièmes transistors étant commutés activement en réponse aux signaux de sortie des circuits à constante de temps, caractérisé en ce qu'un moyen de filtrage est prévu entre les fils de maintien et la source de courant de décharge commune pour filtrer les variations du courant passant des fils de maintien à la source de courant de décharge commune, le moyen de filtrage étant couplé aux fils de maintien par l'intermédiaire des deuxièmes transistors.

2. Dispositif de mémoire selon la revendication 1, dans lequel les deuxièmes transistors ($T_{21}$, $T_{22}$) sont des transistors NPN comportant chacun un collecteur connecté au fil de maintien ($HL_1$, $HL_2$) correspondant, une base connectée à la sortie du circuit à constante de temps correspondant, et un émetteur, le moyen de filtrage comprenant une résistance ($R_1$, $R_2$) connectée entre l'émetteur de chacun des deuxièmes transistors NPN et la source de courant de décharge commune ($Q_1$, $R_{01}$).

3. Dispositif de mémoire selon la revendication 1, dans lequel les deuxièmes transistors ($T_{21}$, $T_{22}$) sont des transistors NPN comportant chacun un collecteur connecté au fil de maintien ($HL_1$, $HL_2$) correspondant, un émetteur connecté à la source de courant de décharge commune ($Q_1$, $R_{01}$) et une base, le moyen de filtrage étant constitué par les deuxièmes transistors comportant chacun une résistance ($R_1$) connectée entre la base du deuxième transistor NPN et la sortie du circuit à constante de temps correspondant.

4. Dispositif de mémoire à semiconducteur du type statique comprenant un ensemble de paires de fils de mot ($WL_1$, $WL_2$) et de fils de maintien ($HL_1$, $HL_2$); un ensemble de cellules de mémoire ($MC_1$, $MC_2$) connectées chacune entre les paires des fils de mot et des fils de maintien; un ensemble de sources de courant de maintien ($IH_1$, $IH_2$) connectées entre les fils de maintien respectifs et une source de tension ($V_{EE}$), pour faire passer d'une façon continue des courants de maintien des fils de mot dans les fils de maintien par l'intermédiaire des cellules de mémoire; et un circuit de décharge de fil de mot ($DIS_1$, $DIS_2$) comprenant des premiers transistors ($T_{11}$, $T_{12}$) comportant des bases connectées aux fils de mot respectifs pour détecter les variations des potentiels électriques des fils de mot, des circuits à constante de temps ($C_1$, $R_{11}$) pour retarder les signaux de sortie des premiers transistors, une source de courant de décharge commune ($Q_1$, $R_{01}$), et des deuxièmes transistors ($T_{21}$, $T_{22}$) insérés respectivement entre les fils de maintien et la source de courant de décharge commune, les deuxièmes transistors étant commutés activement en réponse aux signaux de sortie des circuits à constante de temps, caractérisé en ce qu'un moyen de filtrage est prévu entre les fils de maintien et la source de courant de décharge commune pour filtrer les variations du courant passant des fils de maintien dans la source de courant de décharge commune, le moyen de filtrage étant fourni par les deuxièmes transistors dont chacun est une transistor NPN ($T_{21}'$) comportant un émetteur connecté au fil de maintien ($WL_1$) correspondant, un collecteur connecté à la source de courant de décharge commune ($Q_1$, $R_{01}$), et une base connectée à la sortie du circuit à constante de temps correspondant.

Fig. 1

Fig. 2A

Fig. 2B

Fig. 2C

Fig. 3

Fig. 4